# EUROPEAN PATENT SPECIFICATION

(11) **EP 1 099 207 B1**
(45) Date of publication and mention of the grant of the patent: **27.03.2002**
(21) Application number: 99937403.6
(22) Date of filing: 22.07.1999
(51) Int. Cl.: G09F 9/30

(54) **ELECTRONIC DISPLAY**
ELEKTRONISCHE ANZEIGE
DISPOSITIF D'AFFICHAGE ELECTRONIQUE

(30) Priority: 22.07.1998 US 93689 P
(43) Date of publication of application: 16.05.2001
(73) Proprietor: E-Ink Corporation, Cambridge, MA 02138-1002 (US)
(72) Inventor: ALBERT, Jonathan, D., Cambridge, MA 02139 (US)
(74) Representative: Cole, David John
(86) International application number: US9916652
(87) International publication number: WO0005704

(56) References cited:
- EP-A- 0 180 685
- US-A- 5 497 171

## Description

The present invention relates to an electronic display and more specifically to an electrode arrangement for an electronic display.

Electronic displays often use composites of rectangular pixels as the basis of image presentation. However, displays of images containing diagonal lines or curves suffer from jagged edges when rectangular pixels are used.

One solution is to employ non-rectangular pixels, such as an array of triangles. This method results in a more pleasing display of images containing diagonal lines, particularly when the pixels used are large. Triangular pixels, however, are inappropriate for imaging curves.

Electronic displays are also frequently used to image text. A standard presentation technique is to create a matrix of rectangular pixels; however, this technique also suffers from the problem of creating images with jagged edges. Alternatively, non-rectangular pixels can be organized into rectangular arrays of rows and columns (typically, 5 columns by 7 rows) to generate displays of complex shapes, such as the letters of the alphabet. In this way, curves can be imaged by employing stand-alone pixels which are themselves circular, hexagonal, or some other appropriate shape (such as a field of LEDs). However, while avoiding jagged edges, the image produced is still pixelated and can be difficult to read as well as aesthetically displeasing.

So-called "mosaic displays" overcome some of these problems. In a simple example of a mosaic display, a matrix of rectangular pixels is further sub-divided into triangular pixels. When a diagonal edge of a shape is to be imaged, the display selectively activates the triangular pixels along the edge of the image, thereby creating a smooth line.

While this technique can create a better image, it is costly because of the increased number of pixels required. For example, if each rectangle of a 5 column x 7 row matrix were subdivided into four triangles, then 140 pixels would be required instead of 35 pixels. Because the cost of electronic displays is often driven by the number of pixels in the display, the cost of a mosaic display, such as the one described, would be quadrupled. Therefore, few displays with 140 pixels exist.

By focusing on the problem of displaying text, the present invention provides an electronic display that consolidates pixels into complex shapes while attempting to minimize the number of pixels used in such a display.

The present invention provides an electrode structure according to claim 1. The present invention also provides an electronic display comprising the electrode structure. The electronic display generates images having smooth, uninterrupted contours while using a minimum number of pixels. The present invention permits a smooth, fully-formed alphabet to be displayed.

In one embodiment of the invention, the electrode structure comprises a plurality of electrodes, each configured to form contour elements, or pixels, having a recognizable shape (e.g., a parallelogram, such as a rectangle, a triangle, and a curve). When placed in proximity to display elements having electrically-responsive optical properties, the electrode structure can facilitate the display of an image by transmitting an electric charge through selected groupings of electrodes, thereby altering the optical properties of the display elements nearest to those electrodes. The contours of the image thus reflect the contours of the electrodes that are selectively discharged.

In another embodiment of the invention, the electrode structure comprises a plurality of electrodes forming an array of cells arranged in three columns (c1 ... c3) and at least seven rows (r1 ... r≥7). A first group of cells is subdivided into a plurality of pixels per cell while a second group of cells comprises a single pixel per cell. While the pixels may be a variety of shapes, the electrode structure comprises at least one pixel in the shape of a parallelogram (e.g., a rectangle), at least one triangular pixel, and at least one curved pixel.

In one detailed embodiment, rows r3, r5, and r9 include at least one curved pixel, rows r3, r4, r5, r6, and r7 include at least one triangular pixel, and rows r1 and r2 include at least one pixel which comprises a parallelogram (e.g., a rectangle). In another detailed embodiment, rows r3, r4, r5, r6, and r7 include pixels that are separated from adjacent pixels through a diagonal separation line which extends through multiple rows and columns. In another embodiment, the pixels in columns c1 and c3 are symmetrical.

In one embodiment of the invention, the electrode structure may be stretched by taking the top of the electrode and moving it left to right (or right to left) by a predetermined amount, for example, by 30 degrees, to provide additional variety in pixel shapes. In a further embodiment, the electrode structure is stretched to generate at least one pixel which is a parallelogram.

The present invention also relates to a method of manufacturing an electrode structure. The method includes the step of forming a plurality of electrodes on a substrate to produce an array of cells arranged in three columns (c1 ... c3) and at least seven rows (r1 ... r≥7), and subdividing a first group of cells into a plurality of pixels per cell, thereby forming at least one pixel which comprises a parallelogram (e.g., a rectangle), at least one triangular pixel, and at least one curved pixel. In one detailed embodiment, the method further comprises subdividing the first group of cells to separate adjacent pixels through a diagonal separation line which extends through multiple rows of rows r3, r4, r5, r6, and r7.

In another embodiment, the present invention provides a method of manufacturing an electrode structure which includes the step of forming a plurality of electrodes on a substrate to produce an array of cells arranged in three columns (c1 ... c3) and nine rows (r1 ... r9). In one detailed embodiment, the step of producing the array comprises forming fifty-one pixels, fifty-three pixels, sixty-three pixels, or sixty-four pixels. In a further embodiment of the invention, the method comprises forming columns having equal width and rows having equal height. In still another embodiment, the method further comprises subdividing at least one cell of each of rows r1, r4 and, r7 to create curved pixels, subdividing at least one cell of each of rows r3, r5, and, r9 to create curved pixels, and/or subdividing at least one cell of each of rows r3, r4, r5, r6 and r7 to create triangular pixels.

The present invention also provides an electrophoretic display comprising an electrode structure in communication with a display media. The display media comprises a plurality of display elements having electrically-responsive optical properties. The electrode structure addresses the display media to selectively alter the optical properties of the display elements, allowing the display media to display images of alphanumeric characters that are visually pleasing. In a further embodiment of the invention, drive lines are dispersed on the side of the substrate different from the side on which the plurality of electrodes is disposed. In another embodiment of the invention, the display media includes non-light emissive elements such as liquid crystals, bichromal spheres, rotating round balls, or microencapsulated electrophoretic display suspensions (e.g., electronic ink). In a further embodiment of the invention, the electrode structure is in communication with a control system which controls the magnitude, timing, and duration of an electric charge transmitted through selected electrodes of the electrode structure.

The present invention also relates to a method of generating an electronic display, and in particular a mosaic display. The method includes the steps of: (a) providing a display media including a plurality of display elements with electrically-responsive optical properties in proximity to an electrode structure, the electrode structure comprising a plurality of electrodes, and (b) addressing the plurality of display elements. In another embodiment of the invention, the method comprises applying a voltage to at least one of the plurality of electrodes to selectively alter the optical properties of at least display element relative to another. In another embodiment of the invention, step (a) comprises providing display elements which are non-light emissive elements, such as liquid crystals, bichromal spheres, rotating round balls, or microencapsulated electrophoretic display suspensions (e.g., electronic ink). In another embodiment of the invention, the method comprises the step of selectively altering the optical properties of a plurality of display elements to display at least one alphanumeric character. In a further embodiment of the invention, the method comprises providing a control system and controlling any of: the magnitude, timing, and duration of an electric charge transmitted through at least one of the plurality of electrodes.

The foregoing and other objects, features and advantages of the present invention, as well as the invention itself, will be more fully understood from the following description of preferred embodiments, when read together with the accompanying drawings, in which:
Figure 1 shows a top schematic view of an electrode structure for addressing an electronic display according to one embodiment of the invention.
Figure 2 is a flow diagram depicting a method of generating an electrophoretic display according to one embodiment of the invention to create text alphabets.
Figure 3 shows a top view of a display element addressed by an electrode structure according to one embodiment of the invention. The display element displays a complete English alphabet and Arabic numbers.
Figure 4A shows an electrode structure according to one embodiment of the invention. Figure 4B shows addressing circuitry that can be used with the electrode structure shown in Figure 4A. Figure 4C shows the electrode structure of Figure 4A superimposed on the addressing circuitry of Figure 4B; the electrode structure is shown in phantom.
Figure 5 shows an addressing scheme for the electrode configuration according to one embodiment of the invention which includes fifty-one pixels.
Figure 6 shows an addressing scheme according to one embodiment of the invention which includes fifty-three pixels.
Figure 7 shows a cross-sectional view of an encapsulated electrophoretic display according to one embodiment of the invention.
Figure 8 shows one embodiment of the invention in which the electrode structure is stretched.
Figure 9 shows addressing circuitry according to one embodiment of the invention which may be used with the electrode structure in Figure 8.

The present invention broadly relates to electrode structures for addressing an electronic display to facilitate the formation of an image with smooth, uninterrupted contours. In one embodiment of the invention, the electrode structure comprises a plurality of electrodes, each configured to form contour elements, or pixels, having a recognizable shape (e.g., a rectangle, a triangle, a curve). In one embodiment of the invention, the electrode structure is placed in proximity to display elements having electrically-responsive optical properties. When an electric charge is transmitted through a selected grouping of electrodes, the optical properties of the display elements nearest to the electrodes are altered, forming an image whose contours are similar to the contours of the selected electrodes. The displayed images have uses in a variety of applications, including, but not limited to, advertising, information dissemination, education, and entertainment.

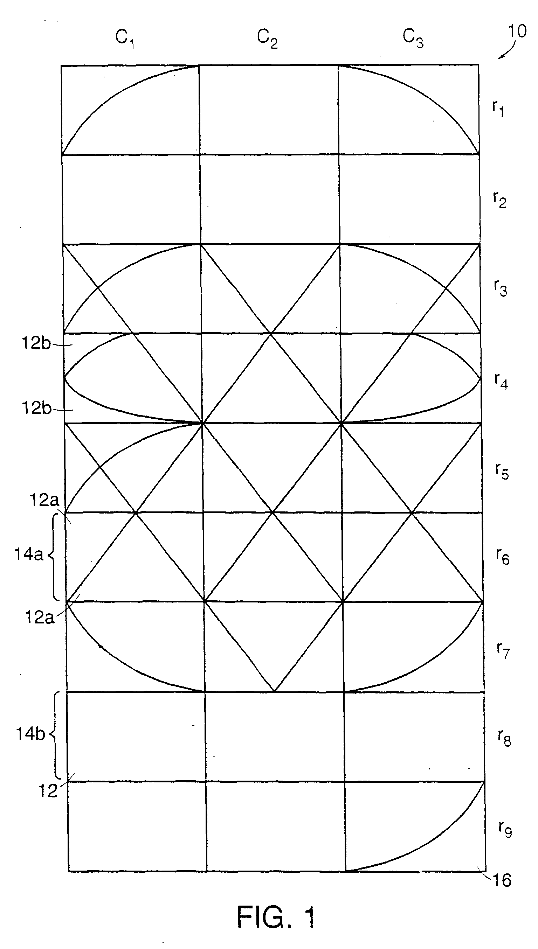

Referring now to Figure 1, an electrode structure 10 is shown that allows a set of alphanumeric characters to be imaged using only sixty-three pixels. The electrode structure 10 comprises a plurality of electrodes forming an array of cells 14 arranged in three columns (c1, c2, and c3) and nine rows (r1 ... r9). The three columns (c1, c2, and c3) have approximately the same width. The nine rows (r1 ... r9) have approximately the same height. The three columns (c1, c2, and c3) and nine rows (r1 ... r9) form twenty-seven cells (c1, r1 ; c2, r1; c3, r1; c1, r2;...c3, r9). In the embodiment shown in Figure 1, cells c1, r1; c3, r1; c1, r3; c2, r3; c3, r3; c1, r4; c2, r4; c3, r4; c1, r5; c2, r5; c3, r5, c1, r6, c2, r6, c3, r6; c1, r7; c2, r7; c3, r7, and c3, r8, r9, are subdivided into multiple pixels. Other cells, c2, r1; c1, r2; c2, r2; c3, r3; c1, r8; c2, r8, c3; r8, c1, r9; and c2, r9, form a single pixel. In the embodiment depicted in Figure 1, some of the pixels are rectangular, some are triangular, and some are curved.

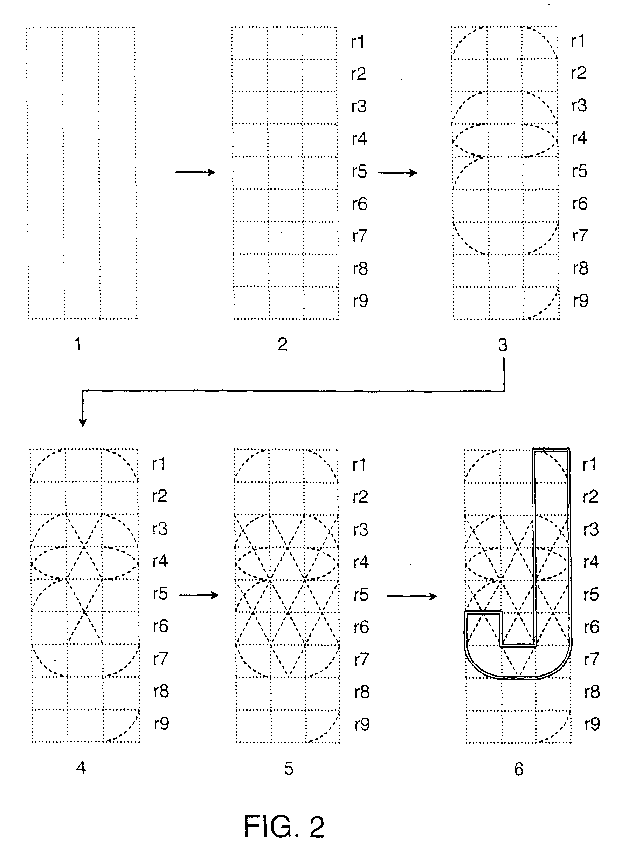

As shown in Figure 2, the shapes of the various pixels can thus contribute to the various contours of different alphanumeric letters. For example, the curved pixels in row r1 together define a substantially convex curve which can form the curved portions of a letter with a curved upper surface, such as the letter "C." By selectively applying a voltage to all but only one of the curved cells in row r1, for example, the upper right pixel in c3, r1, a letter can be imaged which comprises only a partially curved surface, such as the letter "B." Similarly, as the pixels in row r3 also define a substantially convex curve, selectively applying a voltage to cells in row 3 can image the contours of a letter with a curved side, such as the letter "R." The pixels in row r7 together define a substantially concave curve, and therefore can be used to image the contours of a letter with a curved lower surface, such as the letter "J." Rows r5 and r9 also include curved pixels and can also contribute to letters with curved sides, and curved lower surfaces, respectively. The pixels in row r4 together define both a substantially convex curve and a substantially concave curve and can contribute to such letters as "V" and "Y." The cells in columns c1, c2 and c3 from rows r3 to r7 are diagonally divided to define substantially triangular pixels. Selectively applying a voltage to pixels in these cells can display images of letters such as "W," which comprise triangularly shaped central elements.

In one embodiment, the invention provides a method for creating beautiful text alphabets with a minimum number of pixels. The general method for displaying an upper and lower case English alphabet is shown schematically in Figure 2 and includes: (1) providing an electrode configuration which has three columns of cells of substantially even width; (2) further dividing the cells into nine rows of substantially even height, forming twenty seven cells; (3) subdividing some of the cells in rows r1, r3, r4, r5, r7, and r9 into curved pixels; (4) diagonally subdividing some of the cells in the middle rows; (5) subdividing additional cells into pixels to form contour elements suitable for generating a desired image(s), and (6) selectively applying a voltage to different pixels in the display element, generating a display such as an image of a letter. Types of text which may be displayed include, but are not limited to Times New Roman, Arial, Albertus Mono, Andale Mono, Antique Mono, Gothic, Helvetica, Bookman, Bookshelf, Courier, Coronet, Garamond, Lucida, Univers, and Tahoma. Text may be Roman, Latin, Cyrillic, or in the form of ideograms. In a further embodiment of the invention, italicized letter(s) may be displayed.

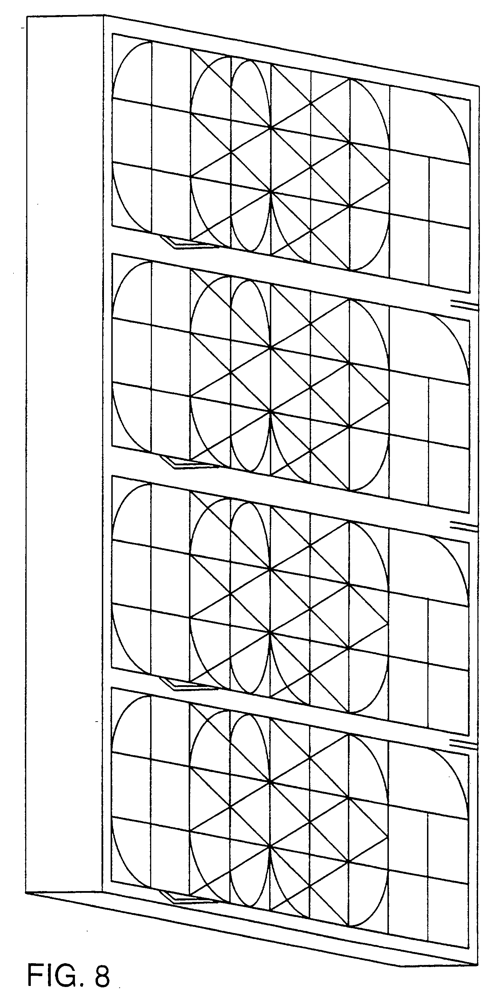

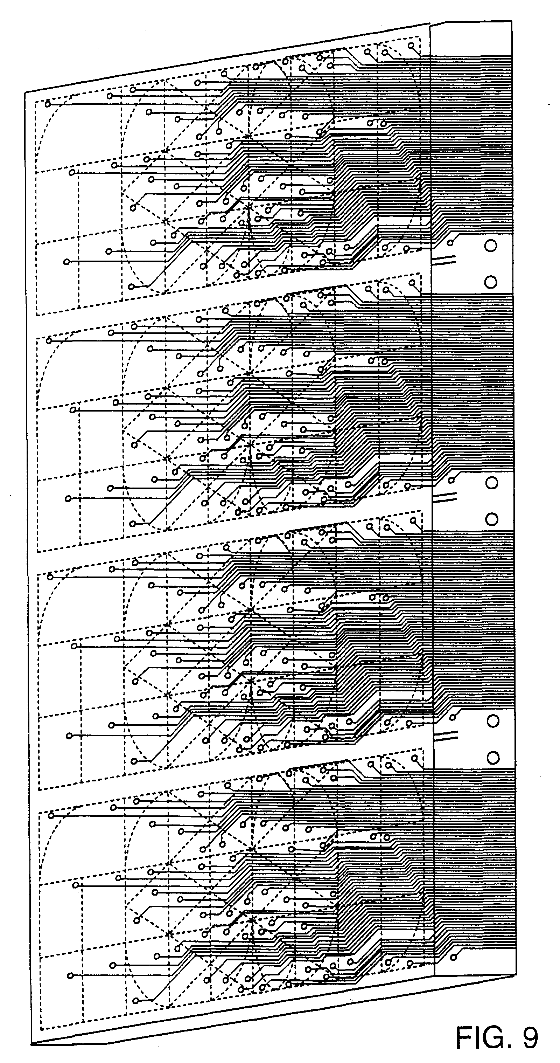

The general method described above may be employed to create other mosaic designs, including letters of non-English alphabets and non-text images. Images of objects comprising composites of straight and curved lines may be generated by adjusting the display element to consolidate of pixels, add new pixels (such as for accent marks for some languages), or subdivide pixels into additional pixels to support new characters or to provide greater resolution. The method may be further enhanced by subsequently applying a topological transform for alternate visual effect, for example, skewing , rotating, stretching, warping, or distorting all or portions of the pixel configuration. In one embodiment of the invention, the electrode structure may be stretched by taking the top of the electrode and moving it left to right (or right to left) by a predetermined amount, for example, by 30 degrees, to provide additional variety in pixel shapes. In one embodiment the electrode is stretched to generate at least one pixel which is a parallelogram. Figure 8 shows an embodiment of the invention where the electrode structure is stretched. Figure 9 shows addressing circuitry that may be used with such an electrode structure. Still or moving images are encompassed within the scope of the present invention.

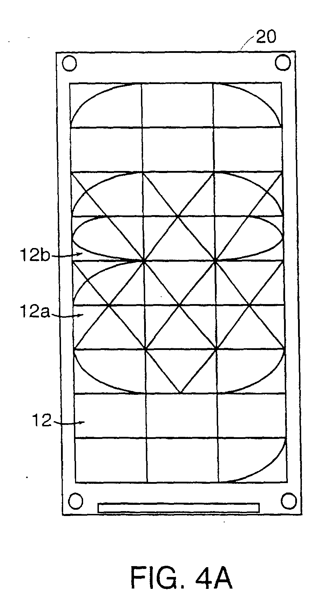

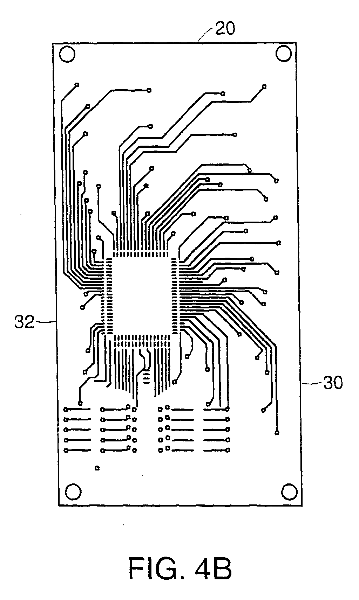

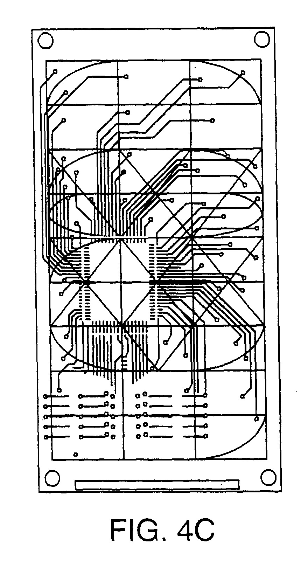

As shown in Figure 4A, an electrode structure comprising 63 pixels (i.e., consolidating adjacent's pixels , c3r8 and c3, r9) can be used to display all letters of the English Alphabet in both upper case and lower cases, as well as Arabic numbers. The addition of the 64^{th} pixel allows the electrode configuration 10 to retain a regular rectangular array and thereby support a graphical display in addition to text. Individual pixels 12, 12a, 12b are electrically isolated from adjacent pixels by an insulator so that the application of voltage to one pixel does not activate a neighboring pixel. The electrode pattern shown in Figure 4A is generated using any appropriate fabrication technique such as printing. Any space between adjacent pixels may be left to avoid such adjacent activation, it being understood that a minimal gap will result in a more pleasing display.

Figure 4B shows addressing circuitry that can be used with the electrode structure of Figure 4A. The circuitry connects the electrode structure such as the one shown in Figure 4A to an electronic control system by a plurality of leads. For example, lead 30 connects each pixel 12, 12a, 12b to an electronic control circuit 32. The electronic control circuit 32 allows a voltage to be selectively applied to individual pixels or groups of pixels in the electrode structure. Any suitable driver chip may be used. The 63 pixel configuration is particularly suitable for a driver chip with 64 lines, allowing the 64^{th} line to be used for control of an opposing electrode. For example, in a configuration in which the mosaic is used as a rear electrode for a display, the opposing electrode could be a top electrode. A 51 and 53 pixel configuration achieves legible fonts with lower pixel count by reducing the number of required drive lines.

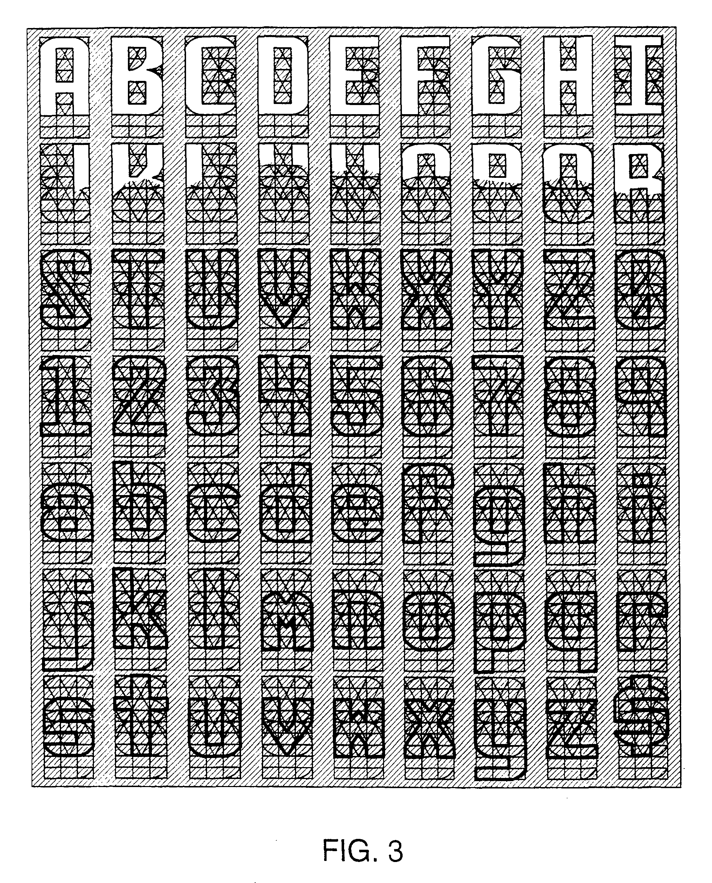

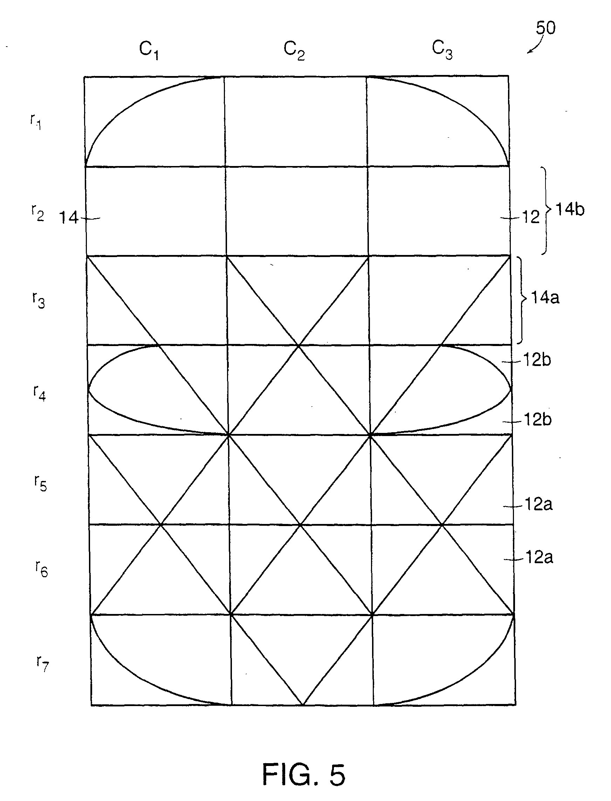

Referring to Figure 5, an electrode structure 50 is shown which includes 51 pixels. This electrode structure 50 is also capable of displaying all of the upper-case alphabets and Arabic numbers as illustrated in Figure 3. The electrode structure 50 includes three columns (c1, c2, c3) and seven rows (r1 ... r7). The three columns (c1, c2, and c3) have approximately the same width, while the seven rows (r1 ... r7) have approximately the same height. The three columns (c1, c2, and c3) and seven rows (r1....r7) form twenty-one cells 14. Some of the cells 14a are subdivided into multiple pixels 12a, 12b. Other cells14b form a single pixel 12 per element 14b. Some of the pixels comprise parallelograms (e.g., rectangles) (12), some are triangular (12a), while still others (12b) are curved. The pixels in row r1 together define a substantially convex curve and may be used to display the curved upper surface of a letter (e.g., "C"). The pixels in row r7 define a substantially concave curve and may be used to display the curved lower surface of a letter (e.g., "J"). Other aspects of letters or shapes can be formed using the pixels in row 4 (defining both a substantially concave curve and a substantially convex curve), and the pixels in columns c1, c2, and c3 ranging from rows r3 to r6 (diagonally divided to define substantially triangular pixels 12a, 12b).

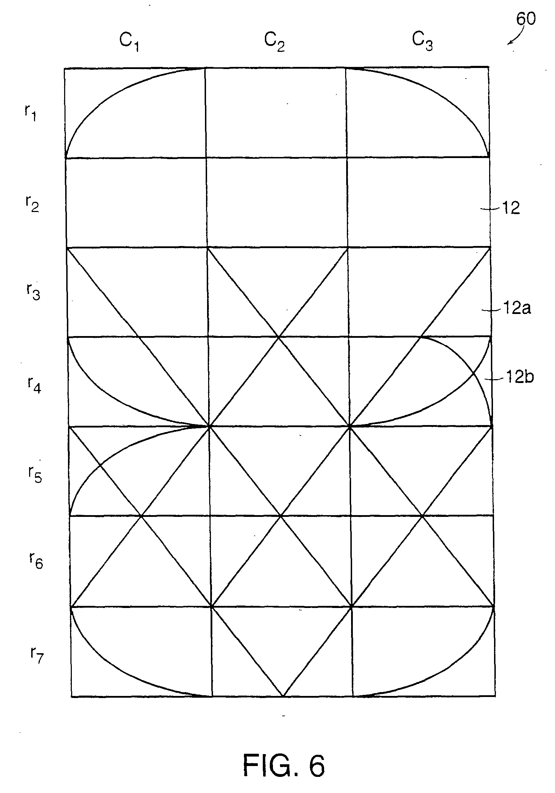

Figure 6 illustrates an electrode structure 60, which includes fifty-three pixels 12, 12a, 12b. The fifty-three pixels 12, 12a, 12b, are capable of displaying all of the upper case letters of the English alphabet and Arabic numbers. The electrode structure 60 is substantially similar to the electrode structure 50 of Figure 5. The only difference is the arrangement of the pixels in row 4. The cells c1, r4 and c3, r4 are subdivided into five pixels in the electrode structure 60 of Figure 6, whereas they are subdivided into four pixels in the electrode structure of Figure 5. This permits a more graceful curve for certain characters, for example, the number 8.

The present invention also provides an electronic display. The display comprises an electrode structure in proximity to a display media comprising a plurality of display elements, the electrode structure addressing the display media. The display elements of the display media have electrically-responsive optical properties and by selectively altering the optical properties of the display elements using the electrode structure, display of images and/or text (moving or still) can be generated. As used herein, the term "proximity'' refers to a distance through which a voltage may be applied to the display element thereby to alter its optical properties in a localized manner. In one embodiment of the invention, the electrode structure is adjacent to the display media. In further embodiment of the invention, the electrode structure contacts the display media.

The electrode structures disclosed herein can be used to address a variety of different types of display elements, including, but not limited to, non-light emissive display elements such as liquid crystals, bichromal spheres, and rotating round balls.

The invention also broadly relates to encapsulated electrophoretic displays using the electrode structure that can be manufactured easily and at low cost. The encapsulated electrophoretic displays consume little power and can be incorporated into a variety of applications including, but not limited to, the display of images and/or text (moving or still).

In one embodiment of the invention, the encapsulated electrophoretic displays are printed or coated on a wide variety of flexible and rigid substrates. As used herein, the term "printing" includes all forms of printing and coating, including, but not limited to, premetered coatings such as patch die coating, slot or extrusion coating, slide or cascade coating, and curtain coating: roll coating such as knife over roll coating, forward and reverse roll coating, gravure coating, dip coating, spray coating, meniscus coating, spin coating, brush coating, air knife coating, silk screen printing processes, electrostatic printing processes, thermal printing processes, photolithography, and other similar techniques. Thus, the resulting display can be flexible. Further, because the display media can be printed (using a variety of methods), the display itself can be made inexpensively.

In one embodiment of the invention, the encapsulated electrophoretic display comprises an electrode structure addressing a plurality of display elements. In one embodiment of the invention, display elements comprise particles (light scattering and/or light absorbing) that move in response to an electric charge. Once the electric charge is removed, the particles are generally stable (e.g., bistable). However, in applications where it is desirable to change an image over time, a subsequent electric charge may be applied to alter the prior configuration of a particle. A display in which particles, ordered by an electric charge, take on a selected configuration can be used to generate many different types of images.

Exemplary particles used, include, but are not limited to, colored particles, light-absorbing particles, light-scattering particles, transparent particles, and luminescent particles. Luminescent particles include, but are not limited to, zinc sulfide particles which can be encapsulated within an insulative coating to reduce electrical conduction. Suitable particle materials include titania, which may be coated in one or two layers with a metal oxide, such as aluminum oxide or silicon oxide. Particles may further include scattering or absorbing pigments, such as neat pigments, dyed or laked pigments, and pigment/polymer composites. Useful pigment dyes are typically fluid-soluble and may further be part of a polymeric chain. Dyes may be polymerized by thermal, photochemical and chemical diffusion processes.

In a further embodiment of the invention, particles are suspended in a high resistivity fluid and either absorb or scatter light. The suspending fluid may be a single fluid, or may be a mixture of two or more fluids. The suspending fluid, whether a single fluid or a mixture of fluids, may have its density substantially matched to that of the particles within the capsule. The suspending fluid may be a halogenated hydrocarbon, such as tetrachloroethylene. The halogenated hydrocarbon may also be a low molecular weight polymer such as poly(chlorotrifluoroethylene). The degree of polymerization for the latter polymer may be from about 2 to about 10. The fluid may be clear or dyed. In one embodiment of the invention, the particles have a refractive index that substantially matches the refractive index of the suspending fluid.

In another embodiment of the invention, the suspending fluid comprises two or more different species of particles. One species of particles absorbs light (e.g., a black particle), while the other species of particle scatters light (e.g., a white particle). In a further embodiment of the invention, the optical properties (light scattering or light absorbing) of one particle is influenced by the movement of a second particle when an electric field is applied. For example, the suspending fluid may contain a plurality of anisotropic particles and a plurality of second particles. In this embodiment of the invention, application of a first electric field can cause the anisotropic particles to assume a specific orientation and present an optical property. Application of a second electric field then causes the plurality of second particles in the suspending fluid to translate, thereby disorienting the anisotropic particles and disturbing the optical property of the anisotropic particles. Alternatively, the orientation of the anisotropic particles may facilitate the translation of the plurality of second particles.

The particles may be dispersed in a binder, in crystals, in spheres, or in capsules. Encapsulated particles can be any size or shape. In one embodiment of the invention, the capsules containing the particles are spherical and have diameters in the millimeter or micron range. In another embodiment of the invention, the capsules are from about ten to about a few hundred microns. The capsules may be configured in a variety of shapes, including, but not limited to, spheres and comer cubes.

Capsules may be formed in, or later dispersed in, a binder. Materials for use as binders include, but are not limited to water-soluble polymers, water-dispersed polymers, oil-soluble polymers, thermoset polymers, thermoplastic polymers, and ultraviolet- or radiation-cured polymers. However, in some cases a separate encapsulation step is not necessary and the electrophoretic suspension of particles may be directly disperse or emulsified into the binder (or a precursor to the binder material) to form a "polymer-dispersed electrophoretic display". As used herein, the term "capsule" or "microcapsule" refers to individual electrophoretic phases of particles, which may include a suspension fluid.

Materials for electrophoretic particles, fluid, capsule membranes, and polymeric binder are selected to be chemically compatible with each other. In some embodiments of the invention, capsule membrane materials are optimized to provided useful surface interactions with electrophoretic particles. Alternatively, in other embodiments, the capsule membranes may act as an inert physical boundary between a suspending fluid and the binder. Similarly, polymeric binder materials are selected to provide the desired adhesive properties to bind a capsule to an electrode surface while providing a barrier to water, oxygen, ultraviolet light, electrophoretic fluid and other material. In some embodiments of the invention, the binder material is selected to be compatible both with the capsule and bounding electrode surfaces and to possess properties that allow for facile printing or coating. The binder material may contain surfactants and cross-linking agents, which can aid in coating or durability.

The encapsulated particles disclosed herein provide a superior display media for signage which is particularly amenable to addressing by a mosaic electrode, such as the one disclosed herein, for several reasons. First, the display media may be deposited in complex segments and icons, allowing edge resolutions of 100 dots per inch (dpi) to 600 dpi or more. Second, the display media can be opaque and can be rear-addressed, permitting the edges of the pixels to be laid very closely together, so that in a shape formed of multiple pixels, the individual pixels are not readily apparent. In a preferred embodiment, the gap between pixels is wide enough to avoid adjacent activation, but narrow enough that the combined edge field effects from adjacent pixel electrodes causing the display media corresponding to the gap to also be activated so that there is no visible seam. Third, the display technology disclosed herein may be easily scaled to form large-sized displays in which the jaggedness of a traditional rectangular 5 column by 7 row array would be overwhelmingly distracting. Particularly, for alphanumeric digits one inch or taller, an encapsulated electrophoretic display media according to the present invention, can create an image that is highly pleasing and yet economically produced.

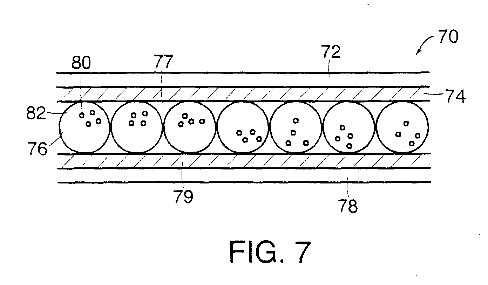

Referring now to Figure 7, an encapsulated electrophoretic display 70 according to one embodiment of the invention includes a top substrate 72 having a patterned electrode configuration 74 provided on the lower side of the substrate 72, display elements/microcapsules 76 dispersed in a binder 77, and a lower substrate 78 having an electrode 79 provided on the upper side of the substrate 78. The display elements/microcapsules 76 include electrophoretic particles 80 dispersed in a fluid 82. The electrode configuration 74 can be of any configuration in accordance with the present invention.

In a further embodiment, the display comprises drive lines which are patterned onto the top of substrate 72 and are in electrical communication with electrode configuration 74, for example, by a conductive vias. In a further embodiment of the invention, the drive lines are dispersed on the side of the substrate different from the side of the substrate on which the plurality of electrodes is disposed.

In one embodiment of the invention, the particles within the display elements/microcapsules 76 may be oriented or translated by placing an electric field across the display elements/microcapsules 76. The electric field may include an alternating-current field or a direct-current field. The electric field may be provided by at least one pair of electrodes disposed adjacent to the display media comprising the display elements/microcapsules.

The encapsulated electrophoretic display disclosed herein can be constructed so that the optical state of the display is stable for some length of time. When the display has two states that are stable in this manner, the display is bistable. If more than two states of the display are stable, then the display is multistable. For the purpose of the present invention, the term bistable indicates a display in which any optical state remains fixed once the addressing voltage is removed. However, the definition of a bistable state depends upon the display's application. A slowly decaying optical state can be effectively bistable if the optical state is substantially unchanged over the required viewing time. For example. in a display that is updated every few minutes, a display image that is stable for hours or days is effectively bistable for a particular application. Thus, for purposes of the present invention, the term bistable also indicates a display with an optical state sufficiently long-lived so as to be effectively bistable for a particular application. Alternatively, it is possible to construct encapsulated electrophoretic displays in which the image decays quickly once the addressing voltage to the display is removed (i.e., the display is not bistable or multistable). Whether or not an encapsulated electrophoretic display is bistable, and its degree of bistability, can be controlled through appropriate chemical modification of the electrophoretic particles, the suspending fluid, the capsule, and binder materials. For example, an encapsulated electrophoretic display may be constructed in which the image decays quickly once the addressing voltage to the display is removed (i.e., the display is not bistable or multistable). Thus, whether the image is static or changes overtime (for example, to give the impression of motion) can be controlled by the user/manufacturer.

## Claims

1. An electrode structure (10; 20; 50; 60) for addressing a display, the electrode structure comprising a plurality of electrodes forming an array of cells (14) wherein a first group of the cells (12a, 12b, 12c) is subdivided into a plurality of pixels per cell and a second group of the cells forms a single pixel per cell, the electrode structure (10; 20; 50; 60) being **characterized in that** the cells (14) are arranged in three columns (c1 . . . c3) and at least seven rows (r1 . . . r≥7), at least one pixel comprises a parallelogram, at least one pixel is triangular, and at least one pixel is curved.

2. An electrode structure according to claim 1 **characterized in that** the plurality of electrodes forms an array of cells (14) arranged in three columns and nine rows.

3. An electrode structure according to claim 1 or 2 **characterized in that** the plurality of electrodes form fifty-one, fifty-three or sixty-four pixels.

4. An electrode structure according to claim 1 or 2 **characterized in that** the plurality of electrodes form sixty-three pixels.

5. An electrode structure according to any one of the preceding claims **characterized in that** the three columns have substantially equal width and/or the rows have substantially equal height.

6. An electrode structure according to any one of the preceding claims **characterized by** any one or more of the following features:
(a) the rows r1, r4, and, r7 include at least one curved pixel;
(b) the rows r3, r5, and, r9 further include at least one curved pixel;
(c) the rows r3, r4, r5, r6, and r7 include at least one triangular pixel;
(d) the rows r1 and r2 include at least one rectangular pixel;
(e) the rows r3, r4, r5, r6, and r7 include pixels that are separated from adjacent pixels through a diagonal separation line which extends through multiple rows;
(f) the pixels in column c1 and the pixels in column c3 are symmetrical.

7. An electrode structure according to any one of the preceding claims **characterized in that** the plurality of electrodes form an array for addressing a display medium to display at least one alphanumeric character.

8. A display comprising a display medium; and an electrode structure according to any one of the preceding claims.

9. A display according to claim 8 **characterized in that** the display medium comprises a plurality of display elements having electrically-responsive optical properties.

10. A display according to claim 8 or 9 **characterized in that** the plurality of electrodes are dispersed on one side of a substrate and drive lines are dispersed on the opposed side of the substrate.

11. A display according to any one of claims 8 to 10 **characterized in that** the display elements comprise encapsulated particles.

12. A display according to any one of claims 8 to 11 **characterized in that** the display medium comprises non-emissive display elements.

13. A display according to any one of claims 8 to 12 **characterized in that** the display elements comprises rotating balls.

14. A display according to any one of claims 8 to 13 **characterized in that** the plurality of electrodes address the display medium to display an alphanumeric character.

15. A display according to any one of claims 8 to 14 **characterized by** a control system for controlling any one or more of the magnitude, timing, and duration of an electric charge discharged from at least one of the plurality of electrodes.

## Patentansprüche

1. Elektrodenaufbau (10; 20; 50; 60) zum Adressieren einer Anzeige, welcher Elektrodenaufbau eine Vielzahl von Elektroden aufweist, die ein Feld von Zellen (14) bildet, wobei eine erste Gruppe von Zellen (12a, 12b, 12c) in mehrere Pixel pro Zelle unterteilt ist und eine zweite Gruppe von Zellen ein einzelnes Pixel pro Zelle bildet, und wobei der Elektrodenaufbau (10; 20; 50; 60) **dadurch gekennzeichnet ist, daß** die Zellen (14) in drei Reihen (c1 ... c3) und wenigstens sieben Zeilen (r1 ... r≥7) angeordnet sind, daß wenigstens ein Pixel die Form eines Parallelogramms hat, daß wenigstens ein Pixel dreieckig ist und daß wenigstens ein Pixel gerundet ausgebildet ist.

2. Elektrodenaufbau nach Anspruch 1,
**dadurch gekennzeichnet, daß** die Vielzahl von Elektroden ein Feld von Zellen (14) bildet, das in drei Reihen und neun Zeilen unterteilt ist.

3. Elektrodenaufbau nach den Ansprüchen 1 oder 2,
**dadurch gekennzeichnet, daß** die Vielzahl von Elektroden einundfünfzig, dreiundfünfzig oder vierundsechzig Pixel bildet.

4. Elektrodenaufbau nach den Ansprüchen 1 oder 2,
**dadurch gekennzeichnet, daß** die Vielzahl von Elektroden dreiundsechzig Pixel bildet.

5. Elektrodenaufbau nach einem der vorhergehenden Ansprüche,
**dadurch gekennzeichnet, daß** die drei Reihen im wesentlichen gleich breit und/oder die Zeilen im wesentlichen gleich hoch sind.

6. Elektrodenaufbau nach einem der vorhergehenden Ansprüche,
**gekennzeichnet durch** eines oder mehrere der folgenden Merkmale:
(a) die Zeilen r1, r4 und r7 weisen wenigstens ein gerundetes Pixel auf;
(b) die Zeilen r3, r5 und r9 weisen weiter wenigstens ein gerundetes Pixel auf;
(c) die Zeilen r3, r4, r5, r6 und r7 weisen wenigstens ein dreieckiges Pixel auf;
(d) die Zeilen r1 und r2 weisen wenigstens ein rechteckiges Pixel auf;
(e) die Zeilen r3, r4, r5, r6 und r7 weisen Pixel auf, die von benachbarten Pixeln **durch** eine diagonale Trennungslinie getrennt sind, die **durch** mehrere Zeilen hindurch verläuft;
(f) die Pixel in der Reihe c1 und die Pixel in der Reihe c3 sind symmetrisch.

7. Elektrodenaufbau nach einem der vorhergehenden Ansprüche,
**dadurch gekennzeichnet, daß** die Vielzahl von Elektroden ein Feld bildet, um ein Anzeigemedium zu adressieren und um wenigstens ein alphanumerisches Zeichen darzustellen.

8. Anzeige mit einem Display-Medium und einem Elektrodenaufbau gemäß einem der vorhergehenden Ansprüche.

9. Anzeige nach Anspruch 8,
**dadurch gekennzeichnet, daß** das Display-Medium mehrere Display-Elemente aufweist, die elektrisch reagierende optische Eigenschaften aufweisen.

10. Anzeige nach den Ansprüchen 8 oder 9,
**dadurch gekennzeichnet, daß** die Vielzahl von Elektroden auf einer Seite eines Substrats verteilt ist und Anschlußleitungen auf der gegenüberliegenden Seite des Substrats verteilt sind.

11. Anzeige nach einem der Ansprüche 8 bis 10,
**dadurch gekennzeichnet, daß** die Display-Elemente gekapselte Partikel sind.

12. Anzeige nach einem der Ansprüche 8 bis 11,
**dadurch gekennzeichnet, daß** das Display-Medium nicht-emittierende Display-Elemente aufweist.

13. Anzeige nach einem der Ansprüche 8 bis 12,
**dadurch gekennzeichnet, daß** die Display-Elemente drehende Kugeln aufweisen.

14. Anzeige nach einem der Ansprüche 8 bis 13,
**dadurch gekennzeichnet, daß** die Vielzahl von Elektroden das Display-Medium adressiert, um ein alphanumerisches Zeichen darzustellen.

15. Anzeige nach einem der Ansprüche 8 bis 14,
**gekennzeichnet durch** ein Steuersystem zur Steuerung der Größe und/oder der Zeit und/oder der Dauer einer elektrischen Ladung, die von wenigstens einer der Vielzahl von Elektroden ausgegeben wird.

## Revendications

1. Structure à électrodes (10; 20; 50; 60) pour l'adressage d'un dispositif d'affichage, la structure à électrodes comprenant une pluralité d'électrodes formant un réseau de cellules (14) dans lequel un premier groupe des cellules (12a, 12b, 12c) est sous-divisé en une pluralité de pixels par cellule et un second groupe des cellules forme un seul pixel par cellule, la structure à électrodes (10; 20; 50; 60) étant **caractérisée en ce que** les cellules (14) sont agencées en trois colonnes (c1 . . . c3) et au moins sept lignes (r1 . . . r≥7), au moins un pixel comprend un parallélogramme, au moins un pixel est triangulaire, et au moins un pixel est incurvé.

2. Structure à électrodes selon la revendication 1, **caractérisée en ce que** la pluralité d'électrodes forme un réseau de cellules (14) agencées en trois colonnes et neuf lignes.

3. Structure à électrodes selon la revendication 1 ou 2, **caractérisée en ce que** la pluralité d'électrodes forme cinquante-et-un, cinquante-trois ou soixante-quatre pixels.

4. Structure à électrodes selon la revendication 1 ou 2, **caractérisée en ce que** la pluralité d'électrodes forme soixante-trois pixels.

5. Structure à électrodes selon l'une quelconque des revendications précédentes, **caractérisée en ce que** les trois colonnes sont de largeur sensiblement égale et/ou les lignes sont de hauteur sensiblement égale.

6. Structure à électrodes selon l'une quelconque des revendications précédentes, **caractérisée par le fait qu'**elle présente l'une quelconque ou plusieurs des caractéristiques suivantes :
(a) les lignes r1, r4, et r7 comprennent au moins un pixel incurvé;
(b) les lignes r3, r5, et r9 comprennent en outre au moins un pixel incurvé;
(c) les lignes r3, r4, r5, r6, et r7 comprennent au moins un pixel triangulaire;
(d) les lignes r1 et r2 comprennent au moins un pixel rectangulaire;
(e) les lignes r3, r4, r5, r6, et r7 comprennent des pixels qui sont séparés des pixels adjacents par une droite de séparation diagonale qui s'étend sur plusieurs lignes;
(f) les pixels de la colonne c1 et les pixels de la colonne c3 sont symétriques.

7. Structure à électrodes selon l'une quelconque des revendications précédentes, **caractérisée en ce que** la pluralité d'électrodes forment un réseau servant à l'adressage d'un support d'affichage pour afficher au moins un caractère alphanumérique.

8. Dispositif d'affichage comprenant un support d'affichage; et une structure à électrodes selon l'une quelconque des revendications précédentes.

9. Dispositif d'affichage selon la revendication 8 **caractérisé en ce que** le support d'affichage comprend une pluralité d'éléments d'affichage ayant des propriétés optiques sensibles à l'électricité.

10. Dispositif d'affichage selon la revendication 8 ou 9 **caractérisé en ce que** la pluralité d'électrodes sont dispersées sur un côté d'un substrat et des lignes de commande sont réparties sur le côté opposé du substrat.

11. Dispositif d'affichage selon l'une quelconque des revendications 8 à 10, **caractérisé en ce que** les éléments d'affichage comprennent des particules encapsulées.

12. Dispositif d'affichage selon l'une quelconque des revendications 8 à 11, **caractérisé en ce que** le support d'affichage comprend des éléments d'affichage non émissifs.

13. Dispositif d'affichage selon l'une quelconque des revendications 8 à 12, **caractérisé en ce que** les éléments d'affichage comprennent des billes rotatives.

14. Dispositif d'affichage selon l'une quelconque des revendications 8 à 13, **caractérisé en ce que** la pluralité d'électrodes réalisent l'adressage du support d'affichage pour afficher un caractère alphanumérique.

15. Dispositif d'affichage selon l'une quelconque des revendications 8 à 14, **caractérisé par** un système de commande servant à commander un paramètre quelconque ou plusieurs parmi l'amplitude, la temporisation, et la durée d'une charge électrique déchargée au niveau d'au moins une des électrodes de la pluralité d'électrodes.
